# FASCICULE DE BREVET EUROPEEN

(11) **EP 3 336 560 B1**
(45) Date de publication et mention de la délivrance du brevet: **26.01.2022**
(21) Numéro de dépôt: 17202694.0
(22) Date de dépôt: 21.11.2017
(51) Int. Cl.: G01R 19/00, H01H 1/00, G01R 31/327, H01H 71/04, G01R 31/52, H01H 47/00

(54) **PROCÉDÉ ET DISPOSITIF DE DIAGNOSTIC D'USURE D'UN APPAREIL ÉLECTRIQUE DE COUPURE, ET APPAREIL ÉLECTRIQUE COMPORTANT UN TEL DISPOSITIF**
VERFAHREN UND VORRICHTUNG ZUR DIAGNOSE DER ABNUTZUNG EINES ELEKTRISCHEN STROMUNTERBRECHUNGSGERÄTS, UND ELEKTRISCHES GERÄT, DAS EINE SOLCHE VORRICHTUNG UMFASST
METHOD AND DEVICE FOR DIAGNOSING WEAR OF AN ELECTRICAL SWITCHING UNIT, AND ELECTRICAL UNIT COMPRISING SUCH A DEVICE

(30) Priorité: 16.12.2016 FR 1662576
(43) Date de publication de la demande: 20.06.2018
(73) Titulaire: Schneider Electric Industries SAS, 92500 Rueil-Malmaison (FR)
(72) Inventeur: REMY, Maël Eugène Alain, 38050 GRENOBLE (FR); DESFORGES, José, 38050 GRENOBLE (FR); ROLARD, François Jean Maurice, 38050 GRENOBLE (FR)

(56) Documents cités:
- EP-A1- 1 475 813
- EP-A1- 2 328 159
- EP-A1- 2 584 575
- EP-A1- 2 975 622
- WO-A1-03/054895
- WO-A1-2005/104155
- WO-A1-2012/072810
- DE-A1-102011 016 895
- DE-B3- 10 352 580
- FR-A1- 2 942 068
- GB-A- 2 158 253
- US-A1- 2007 222 427
- US-A1- 2016 131 713
- LARSEN V ET AL: "Condition Assessment of Contacts in Gas-Insulated Substations", IEEE TRANSACTIONS ON POWER DELIVERY, IEEE SERVICE CENTER, NEW YORK, NY, US, vol. 19, no. 2, 1 avril 2004 (2004-04-01), pages 609-617, XP011109793, ISSN: 0885-8977, DOI: 10.1109/TPWRD.2003.822942

## Description

### DOMAINE TECHNIQUE

L'invention concerne un procédé de diagnostic de l'état d'usure d'un appareil électrique de coupure comportant une phase de contrôle dudit appareil électrique. L'invention concerne aussi un dispositif de diagnostic et un appareil mettant en œuvre le procédé.

### ETAT DE LA TECHNIQUE

Les procédés et dispositifs de diagnostic de l'état d'appareils électriques contrôlent généralement une ou plusieurs caractéristiques électriques en les comparant à un gabarit de valeurs. Parmi ces caractéristiques il y a généralement une tension, un courant ou un repère de temps d'un point remarquable d'un signal électrique. Un procédé de diagnostic de ce type est divulgué dans la demande de brevet EP2584575.

D'autres procédés déterminent l'usure de contacts d'appareils électriques tels que des contacts en évaluant un temps entre deux événements ou la durée d'un événement. Par exemple, un temps entre la commande de l'ouverture ou de fermeture de contacts et le moment effectif de ladite ouverture ou fermeture. Une demande de brevet WO03054895 décrit une façon particulière de détecter l'usure de contacts d'un appareil électrique en fonction du moment de l'apparition d'un courant primaire après un ordre de commande. D'autres documents tels que les EP1475813A1, WO2005/104155A1, DE10352580B3, DE102011016895A1, US2007/222427A1, WO2012/072810A1, EP2328159A1, GB2158253A et US2016/131713A1 divulguent d'autres façons de déterminer l'usure de contacts d'appareil électriques.

Les procédés et dispositifs de diagnostic connus offre des résultats satisfaisants mais ne sont pas faciles à déployer sur des appareils existants ou déjà installés. Généralement, il faut une intervention dans les appareils électriques. De plus, il y a un besoin d'avoir des précisions et des niveaux de certitudes plus élevés pour le contrôle de certains appareils électriques tels que des contacteurs.

### EXPOSE DE L'INVENTION

L'invention a pour but un procédé et un dispositif de diagnostic d'un appareil électrique fournissant un résultat ayant une certitude améliorée et étant facile à mettre en œuvre sur des appareils électriques.

Selon l'invention, qui est décrite dans la revendication 1, dans un procédé de diagnostic de l'état d'usure d'un appareil électrique de coupure comportant une phase de contrôle dudit appareil électrique,
- ladite phase de contrôle utilise :
   - des données d'apprentissage chargées préalablement et correspondant à un type de produit représentatif dudit appareil électrique, et
   - des données d'initialisation correspondant audit appareil à contrôler et mémorisées lors d'une phase d'initialisation,
   et
- ladite phase de contrôle comporte :
   - la mesure et l'acquisition d'une courbe de mesure à l'ouverture dudit l'appareil électrique,
   - la détermination de valeur de descripteurs locaux de ladite courbe de mesure en fonction de valeurs de ladite courbe de mesure, de données d'initialisation enregistrées, et de premières données d'apprentissage chargées,
   - la détermination du positionnement des valeurs de descripteurs locaux de la courbe de mesure par rapport à des secondes données d'apprentissage représentatives de courbes d'évolution de descripteurs représentatifs de caractéristiques prédéfinies dudit signal électrique durant la vie dudit appareil électriques, et
   - la détermination d'une classe d'état globale en fonction desdites valeurs de positionnements des valeurs de descripteurs locaux et de la courbe de mesure par rapport aux dites secondes données d'apprentissage.

De préférence, dans le procédé de diagnostic, la détermination d'une classe d'état globale comporte :
- au moins trois détermination de classes d'état intermédiaires en fonction de positionnements les plus proches desdits descripteurs locaux, et
- la sélection de ladite classe globale en fonction desdites classes intermédiaires.

Avantageusement, un premier descripteur est représentatif de la différence de valeur entre deux points remarquables de la dite courbe de mesure.

De préférence, dans le procédé de diagnostic :
- des données d'initialisation comportent au moins une courbe de référence propre au produit à contrôler enregistrée au début de la vie du produit après stabilisation des mesures, et
- un second descripteur est représentatif de l'écart entre une courbe de mesure et ladite courbe de référence propre, plus la courbe de mesure est éloignée de la courbe de référence propre plus l'appareil sera considéré comme usé.

De préférence, dans le procédé de diagnostic :
- des données d'apprentissage chargées comportent au moins une courbe de référence d'un appareil usé correspondant à un signal électrique durant une ouverture d'un appareil usé, et
- un troisième descripteur est représentatif de l'écart entre une courbe de mesure et ladite courbe de référence usée, plus la courbe de mesure est proche de la courbe de référence usé plus l'appareil sera considéré comme usé.

Avantageusement, un quatrième descripteur correspond à une surface de courbe ou à une intégrale entre deux points remarquables de la courbe le mesure ou à deux seuils de valeurs selon un premier sens de variation et selon un second sens de variation opposé.

Avantageusement, un cinquième descripteur correspond à une variation de valeur d'un point remarquable tel que le changement de signe de la variation d'un signal sur la courbe de mesure.

De préférence, lesdites courbes d'évolution de descripteurs sont chargées sous un format de définition de segments de droite pour réduire l'espace mémoire nécessaire audites données d'apprentissage.

Dans un mode de réalisation préféré, des valeurs desdites courbes d'évolution de descripteurs pré-chargées sont associées à des classes d'état ou d'usure d'appareils à contrôler.

Selon un mode réalisation particulier, le procédé comporte :
- une phase d'apprentissage préalable pour relever durant un nombre de manœuvre prédéterminée des données d'apprentissage représentatives :
   - d'au moins une courbe de référence d'un appareil usé correspondant à un signal électrique durant une ouverture dudit appareil usé, et
   - d'au moins deux courbes d'évolution de descripteurs représentatifs de caractéristiques prédéfinies dudit signal électrique durant la vie dudit appareil électrique,
- une mémorisation desdites données d'apprentissage,
- le chargement desdites données d'apprentissage, et
- l'utilisation des données d'apprentissage dans ladite phase de contrôle dudit appareil électrique.

De préférence, le procédé comporte :
- une phase d'initialisation pour déterminer lesdites données d'initialisation comportant ladite courbe de référence propre du produit à contrôler déterminée :
- après un nombre prédéterminé de mesures, et/ou
- lorsque la courbe de mesure varie très peu entre deux mesures consécutives,
- l'enregistrement de ladite courbe de référence propre, et
- l'utilisation des données d'initialisation dans ladite phase de contrôle dudit appareil électrique.

Selon l'invention, dans un dispositif de diagnostic de l'état d'usure d'un appareil de coupure électrique connecté à une bobine électromagnétique d'actionnement de contacts dudit appareil de coupure électrique, le dispositif de diagnostic comporte un circuit de traitement pour mettre en œuvre le procédé de diagnostic défini ci-dessus.

Dans un mode de réalisation particulier, le circuit de traitement comporte un module de traitement du diagnostic local proche dudit l'appareil relié à un module de traitement extérieur distant dudit appareil.

Selon l'invention, un appareil électrique, comportant des contacts électriques de puissance actionnés par une bobine électromagnétique de commande, comporte un dispositif de diagnostic l'état d'usure de l'appareil de coupure électrique connecté à ladite bobine électromagnétique d'actionnement desdits contacts et mettant en œuvre le procédé de diagnostic défini ci-dessus.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un schéma global d'un appareil électrique comportant un dispositif de contrôle selon un mode de réalisation de l'invention ;
- la figure 2 représente une phase d'apprentissage d'un procédé selon un mode de réalisation de l'invention ;
- la figure 3 représente une phase de chargement d'un dispositif et d'un procédé selon un mode de réalisation de l'invention ;
- la figure 4 représente une phase d'initialisation et de traitement d'un dispositif et d'un procédé selon un mode de réalisation de l'invention ;
- la figure 5 représente une courbe de mesure d'un signal lors de l'ouverture d'un appareil électrique à contrôler ;
- la figure 6 représente une modélisation d'un descripteur pour un dispositif et un procédé selon un mode de réalisation de l'invention ;
- les figures 7 à 11 représentent des courbes d'évolution de descripteurs élaborées lors d'une phase d'apprentissage et utilisées pour d'un dispositif et d'un procédé selon un mode de réalisation de l'invention ;
- la figure 12 montre des tables de décision utilisant des descripteurs et des courbes d'évolution de descripteurs ;
- la figure 13 représente une courbe de mesure de signal pour un appareil en bon état ou neuf et une courbe de mesure de signal pour un appareil usé ;
- la figure 14 représente des étapes de la phase de d'initialisation d'un procédé selon un mode de réalisation de l'invention ;
- la figure 15 représente une phase de contrôle d'un procédé selon un mode de réalisation de l'invention ; et
- la figure 16 représente des étapes d'une phase de contrôle d'un procédé selon un mode de réalisation de l'invention.

### DESCRIPTION DETAILLEE DE MODES DE REALISATION

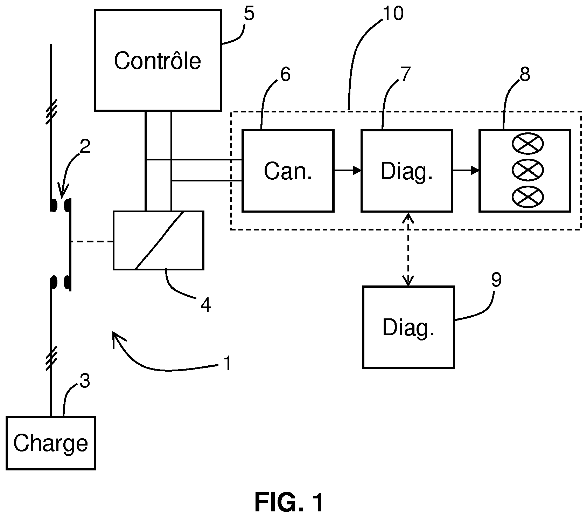

Sur la figure 1, un appareil électrique 1 de type contacteur comporte un ou plusieurs contacts 2 électriques de puissance pour alimenter ou interrompre l'alimentation électrique d'une charge 3. Les contacts électriques sont commandés par une bobine électromagnétique 4. Un circuit 5 de commande ou de contrôle commande la bobine 4 électromagnétique pour fermer ou ouvrir les contacts 2. Le circuit 5 contrôle aussi un courant circulant dans la bobine durant une phase d'appel au moment de la fermeture des contacts et durant une phase de maintien des contacts fermés avec une énergie et un courant de commande réduits.

Un dispositif de diagnostic 10 de l'usure de l'appareil 1 est associé ou fait partie de l'appareil électrique. Ce dispositif 10 reçoit un signal représentatif d'une grandeur électrique telle que la tension ou le courant de la bobine 4 de commande des contacts. Avantageusement, le dispositif 10 est connecté en parallèle sur la bobine pour recevoir un signal de tension généré par la bobine lors de l'ouverture des contacts. Un signal de courant circulant dans la bobine peut aussi être utilisé. Cependant, dans un mode de réalisation préférentiel un signal de tension est avantageusement plus stable et facile à utiliser. Ainsi, le dispositif 10 comporte un convertisseur 6 Analogique-Numérique connecté à la bobine 4, un module de diagnostic 7 connecté au convertisseur pour recevoir le signal et traiter le diagnostic de l'appareil électrique, et un dispositif 8 de signalisation de l'état de l'appareil électrique, notamment son niveau d'usure des contacts. Le module de diagnostic 7 peut aussi être connecté et traiter des données avec un autre module 9 de traitement extérieur ou déporté. Dans ce cas, le dispositif de diagnostic est en deux ou plusieurs parties. Il est également possible que des parties extérieures soient communes à plusieurs dispositifs ou centralisées. Le module de traitement 9 peut assurer la signalisation à distance de l'état de l'appareil. Bien entendu, les communications entre les modules et les dispositifs se font avec ou sans fil.

Ainsi, le contrôle et le diagnostic de l'usure de l'appareil électrique tel qu'un contacteur est fait de préférence par l'analyse de la tension de la bobine à l'ouverture dudit contacteur. Cette tension est représentative de la vitesse du mouvement de la partie mobile du contacteur. Dans ce cas, l'usure des contacts entraine une diminution de la vitesse de déplacement de la partie mobile de l'appareil électrique.

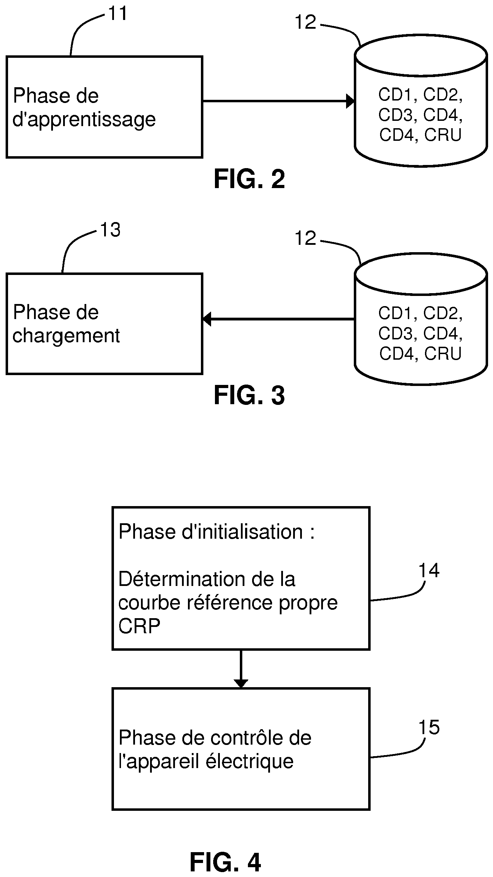

Le diagnostic de l'état d'usure de l'appareil électrique comporte une phase d'apprentissage préalable réalisée sur un nombre important de produits pendant des cycles de durée de vie desdits appareils. Cette phase d'apprentissage permet acquérir des données d'apprentissage qui seront d'abord mémorisées, modélisées et stockées puis chargées sur chaque appareil à contrôler pour le contrôle de sa propre usure. La figure 2 illustre une phase d'apprentissage 11 et le stockage 12 des données d'apprentissage.

Durant la phase d'apprentissage des courbes de mesures sont acquises lors de l'ouverture des appareils en cycle d'usure. Des courbes de mesure représentent un signal électrique qui dure quelques dizaines de millisecondes par exemple 30 ms à 50 ms pour un appareil électrique de taille moyenne. Ces durées peuvent être très différentes selon la taille et le type des appareils. Le signal est généralement échantillonné avec quelques centaines d'échantillon par exemple entre 80 et 500 échantillons mais un nombre différent peut aussi être utilisé, il dépendra de la capacité de calcul d'un processeur utilisé dans le dispositif de diagnostic.

Pendant la phase d'apprentissage, les appareils électriques subissent les quantités de manœuvres permettant de suivre la vie d'un appareil. Pour un contacteur, le nombre de manœuvres peut atteindre par exemple 800000 bien que d'autres valeurs puissent être aussi utilisées. Le nombre de données pouvant être considérable, l'évolution des caractéristiques de l'appareil électrique est définie par des descripteurs D1, D2, D3, D4, D5 associés à des caractéristiques électriques et à des courbes d'évolution CD1, CD2, CD3, CD4, CD5 desdits descripteurs durant la vie d'un appareil électrique. Pour réduire encore la taille des données d'apprentissage qui seront par la suite chargées dans les dispositifs des appareils à diagnostiquer, les courbes d'évolution CD1, CD2, CD3, CD4, CD5 des descripteurs sont enregistrées sous la forme de données représentatives de segments de droites de type a + bx. Une courbe d'évolution peut avoir plusieurs segments de droites successifs définissant la durée de vie d'un appareil. L'ensemble de courbes d'évolution des descripteurs CD1, CD2, CD3, CD4, CD5 forme, sur la vie d'un produit, un espace à plusieurs dimensions. Des parties, portions de courbes ou des valeurs de descripteurs sont associées à des classes d'usure de l'appareil électrique. Vu le nombre de manœuvres des appareils, les courbes de mesures ne sont pas obligatoirement acquises à chaque ouverture. L'acquisition des courbes de mesure peuvent être espacées de manières régulières par intervalles de nombre de manœuvres ou de manières plus pertinentes en fonction de l'évolution des appareils. Par exemple le nombre de manœuvres peut être plus fréquent en fin de vie et très espacé en début de vie.

La phase d'apprentissage fournit également une courbe de référence usée CRU. Cette courbe de référence usée est prélevée sur des courbes de mesure en fin de vie des appareils servant à l'apprentissage. La courbe de référence usée CRU peut être une courbe moyennée sur plusieurs courbes de mesure et/ou sur plusieurs appareils usés.

Ainsi, à la fin de la phase d'apprentissage, les données d'apprentissage telles que les courbes d'évolution CD1, CD2, CD3, CD4, CD5 des descripteurs et la courbe de référence usée CRU sont d'abord mémorisées, modélisées et stockées puis chargées sur chaque appareil pour le contrôle de sa propre usure. Ces données d'apprentissage sont communes à tous les dispositifs de contrôle associé à un même type d'appareil. La figure 3 illustre une phase de chargement 13 de données d'apprentissage préalablement stockées dans des appareils à diagnostiquer.

Dans un premier mode de réalisation préféré, un procédé de diagnostic selon l'invention comporte :
- une phase d'apprentissage 11 préalable pour relever durant un nombre de manœuvre prédéterminée des données d'apprentissage représentatives :
   - d'au moins une courbe CRU de référence d'un appareil usé correspondant à un signal électrique durant une ouverture dudit appareil 1 usé, et
   - d'au moins deux courbes d'évolution de descripteurs CD1, CD2, CD3, CD4, CD5 représentatifs de caractéristiques prédéfinies dudit signal électrique durant la vie dudit appareil électriques,
- une mémorisation des données d'apprentissage,
- le chargement des données d'apprentissage, et
- l'utilisation des données d'apprentissage dans une phase de contrôle 15 de l'appareil électrique.

Dans un mode de réalisation préféré, un procédé de diagnostic selon l'invention comporte aussi une phase d'initialisation 14 pour déterminer des données d'initialisation comportant une courbe de référence propre CRP du produit à contrôler déterminée, et l'utilisation desdites données d'initialisation dans ladite phase de contrôle 15 dudit appareil électrique.

Lors de la phase de contrôle, des descripteurs locaux DL1, DL2, DL3, DL4, DL5 propres à chaque appareil à contrôler sont déterminés lors de l'acquisition de courbes de mesures CM. Ces descripteurs sont du même type que ceux qui ont servis à élaborer des courbes globales CD1, CD2, CD3, CD4, CD5 d'évolution des descripteurs. Dans le mode de réalisation préféré comportant cinq descripteurs D1, D2, D3, D4, D5, ces descripteurs donneront respectivement cinq courbes globales CD1, CD2, CD3, CD4, CD5 d'évolution préalablement élaborées enregistrées et chargées, et respectivement cinq descripteurs locaux DL1, DL2, DL3, DL4, DL5 propres à chaque appareil issu de courbes de mesure lors de l'ouverture de l'appareil électrique.

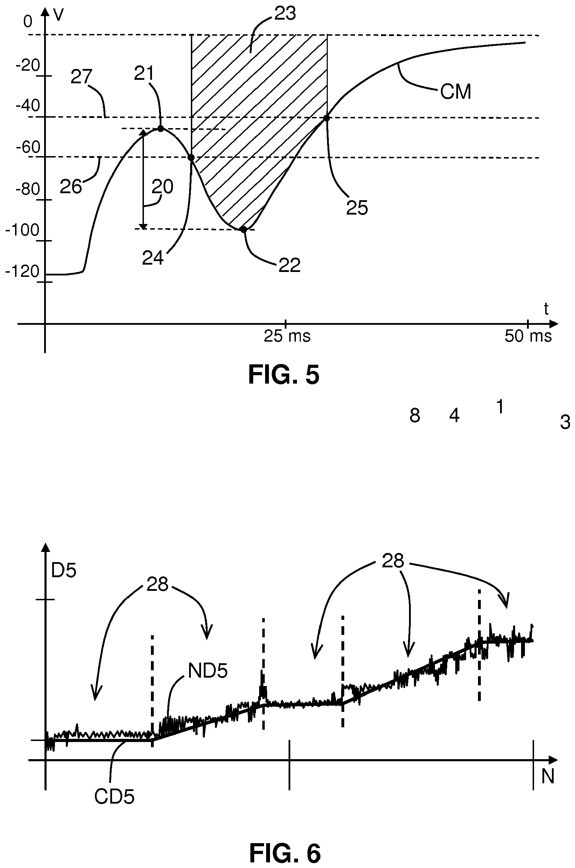

La figure 5 montre une courbe de mesure CM représentative d'un signal de tension électrique une bobine de commande à l'ouverture d'un appareil électrique. Une telle courbe peut être aussi bien une courbe de mesure CM lors de la phase de contrôle d'un appareil électrique qu'une courbe de mesure pendant la phase d'apprentissage pour élaborer les courbes d'évolution des descripteurs.

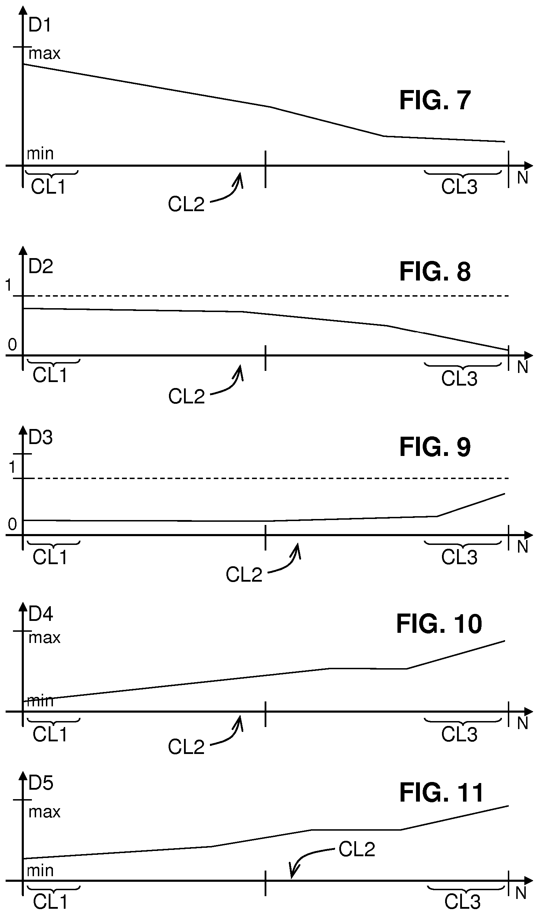

Un premier descripteur D1 est représentatif de l'écart ou la différence 20 de valeur entre deux points remarquables 21 et 22 de la courbe de mesure CM. Ces points 21 et 22 sont avantageusement des points de changement de sens de la variation du signal ou de changement de signe de la dérivée dudit signal de mesure. Sur un premier point 21, le signal était en croissance puis en décroissance en valeurs relatives, et sur un second point 22, le signal était en décroissance puis en croissance en valeur relatives. L'écart de valeur entre le premier 21 point et le second point 22 a tendance à se réduire durant la vie du produit. La figure 7 illustre une courbe CD1 représentative de l'évolution de ce descripteur D1.

Un second descripteur D2 est représentatif de l'écart, de la variation, de la différence, ou de la corrélation entre une courbe de mesure CM d'un signal à mesurer et une courbe CRP de référence initiale ou propre d'un produit à contrôler. Par exemple, en valeurs normées, ce descripteur peut avoir une valeur proche de "1" si la courbe mesurée CM est proche de la courbe CRP de référence propre ou initiale et une valeur proche de zéro "0" si la courbe mesurée CM est très différente ou éloignée de la courbe CRP de référence propre ou initiale. Durant la vie du produit, la valeur du descripteur D2 passe d'une valeur proche de 1 à une valeur proche de zéro. La figure 8 illustre une courbe CD2 représentative de l'évolution de ce descripteur D2. Par conséquent, plus la courbe de mesure CM est éloignée de la courbe de référence propre CRP plus l'appareil sera considéré comme usé.

Un troisième descripteur D3 est représentatif de l'écart, de la variation, de la différence, ou de la corrélation entre une courbe de mesure CM d'un signal à mesurer et une courbe CRU de référence usée d'un produit à contrôler. La courbe référence usée étant chargée au préalable. Par exemple, en valeurs normées ce descripteur peut avoir une valeur proche de zéro "0" si la courbe mesurée CM est très différente ou éloignée de la courbe de référence usée CRU et une valeur proche de "1" si la courbe mesurée CM devient proche de la courbe de référence usée. Durant la vie du produit la valeur du descripteur D3 passe d'une valeur proche de "0" à une valeur proche de "1". La figure 9 illustre une courbe CD3 représentative de l'évolution de ce descripteur D3. Par conséquent, plus la courbe de mesure CM est proche de la courbe de référence usé CRU plus l'appareil sera considéré comme usé.

Un quatrième descripteur D4 est représentatif une intégrale 23 du signal de la courbe de mesure CM entre deux points remarquables 24 et 25. Avantageusement, les points remarquables peuvent être respectivement un premier seuil 26 après le premier changement de sens de la variation du signal et un second seuil 27 après le second changement de sens de la variation du signal. Durant la vie du produit, la valeur du descripteur D4 diminue en valeur absolue. Dans le mode de réalisation décrit, la valeur est négative et se rapproche de zéro en montrant une courbe montante. La figure 10 illustre une courbe CD4 représentative de l'évolution de ce descripteur D3.

Un cinquième descripteur D5 est représentatif de la valeur d'un point remarquable 22 de la courbe CM de mesure. Ce point est avantageusement un point de changement de sens de la variation du signal ou de changement de signe de la dérivée dudit signal de mesure. De préférence, un point remarquable peut être un point 22 de second changement de signe où le signal est en décroissance puis en croissance en valeur relatives. La figure 11 illustre une courbe CD5 représentative de l'évolution de ce descripteur D5. Cette courbe est issue d'une courbe d'apprentissage montrée sur la figure 6. Sur cette figure 6, pendant la phase d'apprentissage un nombre très important de mesure du descripteur D5 ont été réalisées et montrées par une courbe ND5. Ensuite, ces nombreuses valeurs ont été modélisées en segments de droites pour donner la courbe d'évolution du descripteur CD5 qui sera chargée dans les appareils à contrôler. Cette courbe de la figure 11 comprend par exemple cinq segments 28. Le nombre de segment n'est pas limité il est avantageusement compris entre 1 et 20. Cependant, d'autres modes de modélisation sont possibles, par exemple par paliers ou par polynômes.

En début de courbes globales CD1, CD2, CD3, CD4, CD5 d'évolution des descripteurs, les descripteurs sont associés à des classes particulières CL1 d'appareils neufs ou en rodage alors qu'en fin de courbes les descripteurs sont associés à des classes CL3 d'appareils usés. Entre les classes CL1 et CL3, les descripteurs sont associés à des classes CL2 d'appareils en fonctionnement normal.

L'utilisation d'au moins deux ou plusieurs descripteurs D1, D2, D3, D4, D5 permet de détecter avec plus de précision ou de certitude l'état d'usure d'un appareil électrique à contrôler. Les descripteurs décrits ci-dessus dépendent de grandeurs électriques. Cependant d'autres descripteurs peuvent aussi être utilisés en combinant des grandeurs électriques et des grandeurs environnementales telles que la température ou la position horizontale ou verticale d'un appareil. De telles grandeurs peuvent servir à sélectionner des descripteurs en fonction de l'environnement. Les courbes de descripteurs peuvent aussi être sélectionnées en fonction du type d'utilisation particulier de l'appareil électrique. Des données de paramétrage permettant de définir le type de produit ou d'appareil électrique et l'usage dudit appareil sont aussi chargées avec les données d'apprentissage correspondante lors de la phase de chargement.

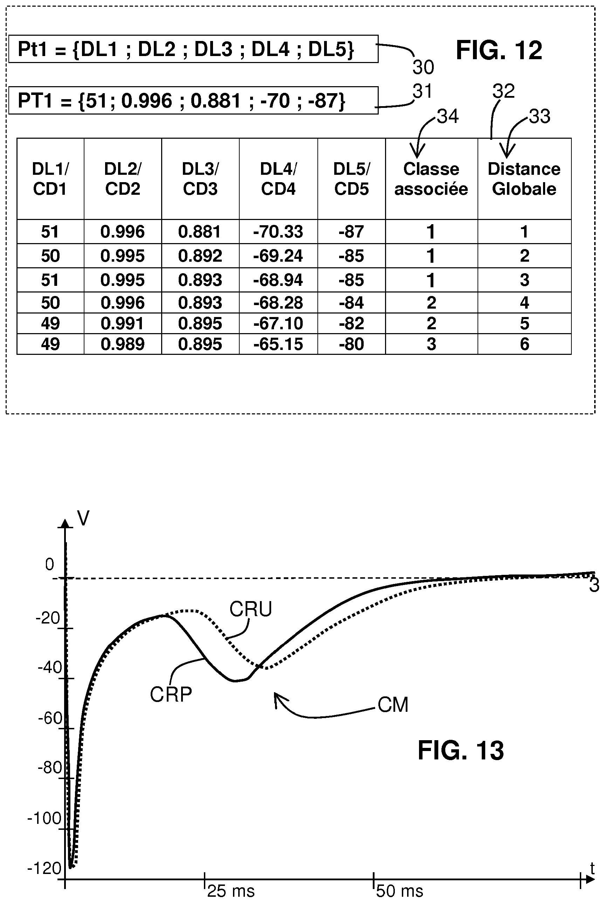

Figure 12 montre des exemples de valeurs de descripteurs D1, D2, D3, D4, D5 et leurs comparaison ou positionnement par rapport à des courbes d'évolution des descripteurs CD1, CD2, CD3, CD4, CD5 selon un mode de réalisation de l'invention. Le cadre 30 montre un formatage d'une courbe de mesure CM en cinq descripteurs Pt1= {D1 ; D2 ; D3 ; D4 ; D5}. Le cadre 31 donne des valeurs normées de ces descripteurs correspondant à un point de mesure ou une courbe de mesure Pt1 {51 ; 0.996 ; 0.881 ; -70 ; -87}. Le cadre 32 montre les situations les plus proches en les classant à partir du plus petit écart global (33). Dans ce cas, il y a six situations (34) les plus proches ayant trois classes d'usure 1, deux classes 2 et une classe 3. Si la décision est faite sur les cinq situations les plus proches, alors le résultat sera la classe d'usure majoritaire, c'est-à-dire la classe 1.

Lorsque les données d'apprentissage sont chargées dans un dispositif prêt à opérer le diagnostic de l'usure d'un appareil électrique tel qu'un contacteur. Une phase d'initialisation permet de mémoriser des données initiales propres à l'appareil à contrôler. Parmi ces caractéristiques initiales, il y a avantageusement l'acquisition d'une courbe de référence propre CRP. Cette courbe de référence est de préférence mémorisée après un rodage de l'appareil correspondant à un nombre prédéterminé de premières ouvertures et/ou lorsque des variations de courbe de mesure CM deviennent stables.

La figure 13 montre deux exemples de courbes. Une première courbe de mesure CM appareil neuf qui peut être aussi une courbe de référence propre CRP, et une courbe de mesure CM appareil usée qui peut être aussi une courbe de référence appareil usé CRU pré-chargée. Les autres courbes de mesure de mesure CM durant la vie de l'appareil vont se situées entre ces deux courbes de références CRP et CRU.

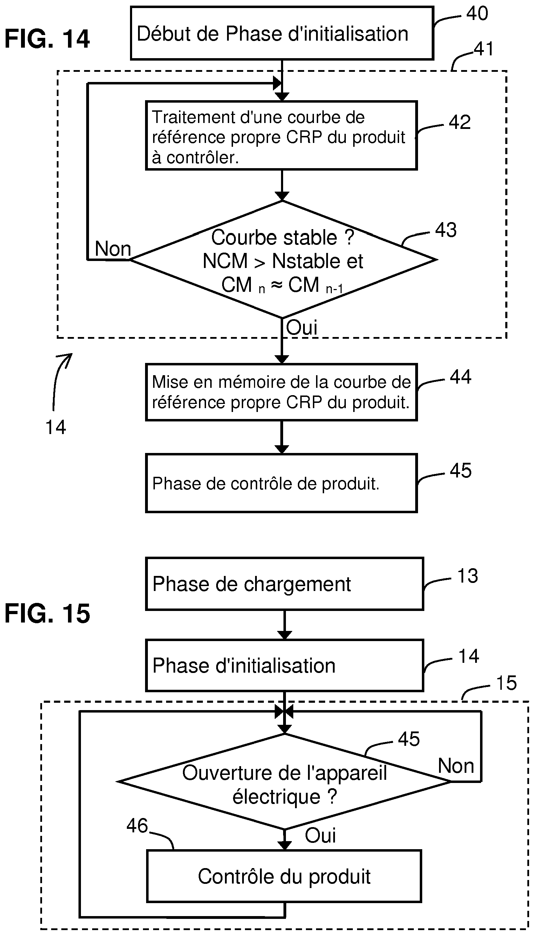

Figure 14 montre un organigramme représentant une phase d'initialisation 14 pour déterminer lesdites données d'initialisation comportant ladite courbe de référence propre CRP du produit à contrôler sur lequel est installé ou associé le dispositif de contrôle. Une étape 40 montre le début de la phase d'initialisation. Un processus 41 de détermination d'une courbe de référence propre CRP comporte une étape de traitement 42 ou sont acquises des courbes de mesures consécutives et une étape 43 de contrôle de la stabilité de la courbe. La courbe CM est reconnue stable après un nombre prédéterminé de mesures Nstable, et/ou lorsque la courbe de mesure CM varie très peu entre deux mesures consécutives CMn et CMn-1.

A une étape 44, la courbe de mesure CM est enregistrée en tant que courbe de référence propre CRP. Après un nombre minimum de manœuvres lorsque les écarts entre les courbes après chaque ouverture deviennent faibles. Cette courbe est représentative des caractéristiques électriques de la tension ou du courant en début de vie du produit après rodage. Elle reste valable jusqu'à la fin de vie du produit. Dans un autre mode de réalisation, pour améliorer encore stabilité de la courbe à enregistrer, la courbe de référence propre CRP peut aussi être une moyenne de quelques courbes CM stables.

Cette courbe CRP de référence propre est notamment utilisée pour déterminé au moins un descripteur D2 dans la phase de contrôle 15 dudit appareil électrique.

La figure 15 montre qu'après la phase de chargement 13 où des données d'apprentissage correspondant à un type de produit représentatif dudit appareil électrique sont chargées préalablement, et la phase d'initialisation 14 où des données d'initialisation correspondant audit appareil à contrôler sont mémorisées, une phase de contrôle 15 lance le contrôle lors de l'ouverture de l'appareil électrique.

Dans ce mode de réalisation particulier, une étape 45 détecte l'ouverture de l'appareil électrique. Lorsque l'ouverture est détectée, une étape 46 effectue le contrôle de l'appareil. Cette détection peut être réalisée par un signal extérieur au dispositif ou par l'analyse du signal de mesure ou de sa variation. La phase de contrôle est de préférence lancée à chaque ouverture de l'appareil électrique. Cependant, elle peut aussi être lancée de manière plus espacée, par exemple après un nombre prédéterminé d'ouvertures. Le contrôle peut aussi dépendre le da durée de vie de l'appareil, par exemple le contrôle peut être moins fréquent en début de vie après rodage et plus fréquent en fin de vie pour plus de précision.

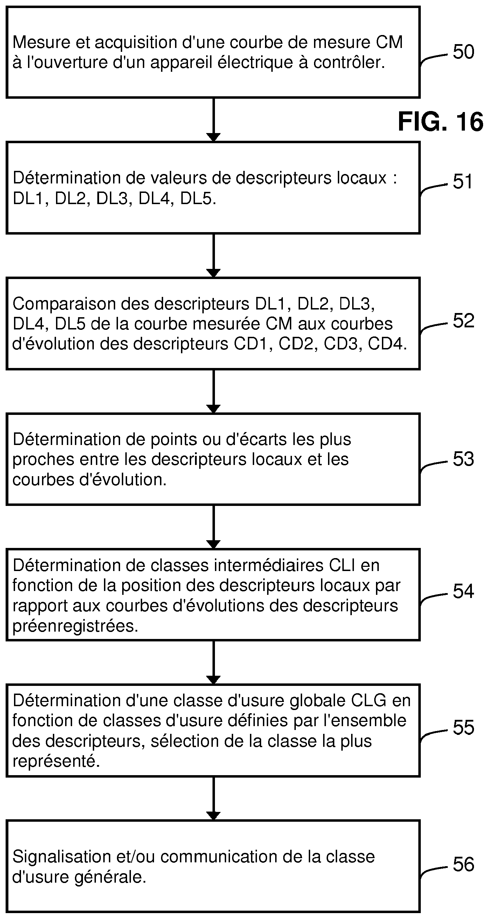

La figure 16 montre un organigramme d'une phase 15 de contrôle avec le détail d'une étape de 46 contrôle selon un mode de réalisation de l'invention.

Ladite phase de contrôle comporte :
- à une étape 50, la mesure et l'acquisition d'une courbe de mesure CM à l'ouverture de l'appareil contrôler,
- à une étape 51, la détermination de valeur de descripteurs locaux DL1, DL2, DL3, DL4, DL5 de la courbe de mesure CM en fonction de ladite courbe de mesure CM, de données d'initialisation CRP enregistrées, et de premières données d'apprentissage telles que la courbe de référence usé CRU,
- à une étape 52, la détermination du positionnement des valeurs de descripteurs DL1, DL2, DL3, DL4, DL5 de la courbe de mesure CM par rapport à des secondes données d'apprentissage chargées telles que des courbes d'évolution de descripteurs CD1, CD2, CD3, CD4, CD5,
- à des étapes 53-55, la détermination d'une classe d'état globale en fonction desdites valeurs de positionnements des valeurs de descripteurs DL1, DL2, DL3, DL4, DL5 de la courbe de mesure CM par rapport à des secondes données d'apprentissage chargées.

De préférence la détermination d'une classe d'état globale comporte :
- à une étape 53, la détermination de points ou d'écarts les plus proches entre les valeurs de descripteurs locaux DL1, DL2, DL3, DL4, DL5 de la courbe de mesure CM et les courbes d'évolution de descripteurs CD1, CD2, CD3, CD4, CD5 correspondantes,
- à une étape 54, au moins trois détermination de classes d'état intermédiaires CLI en fonction de positionnements les plus proches des descripteurs par rapport audites courbes d'évolution de descripteurs,
- à une étape 55, la sélection de ladite classe globale en fonction de résultats desdites classes intermédiaire, et
- à une étape 56, la signalisation ou la communication de la classe d'usure globale de l'appareil.

A l'étape 53, la détermination des écarts les plus proches peut se faire de préférence de manière globale par exemple avec un point définis par les valeurs de tous les descripteurs. Cependant, il peut se faire également individuellement sur chaque descripteur ou de manière mixte ou semi globale avec une partie des descripteurs groupés et une autre partie individuelle.

A l'étape 56, le dispositif 8 de signalisation de l'état de l'appareil électrique peut afficher la classe d'usure globale avec un voyant ou une voie distincte la valeur de classe. Cependant, des valeurs de classe peuvent être regroupées, notamment une classe d'appareil en rodage et une classe de fonctionnement normal peuvent être signalées de manière groupée ou ensembles sur un seul signal.

La description ci-dessus fait référence à cinq descripteurs, cependant d'autres descripteurs peuvent être utilisés pour caractériser le comportement d'un appareil électrique durant sa vie ou sa durée de vie. Le nombre de descripteurs peut aussi être différent, à partir d'un descripteur le procédé et le dispositif permettent de tirer avantage des modes de réalisation de l'invention. Cependant, Un nombre important de descripteurs permet d'avoir un résultat plus précis de l'identification des classes d'usure.

Selon un mode réalisation de l'invention, le dispositif de diagnostic de l'état d'usure d'un appareil de coupure électrique est connecté à une bobine électromagnétique d'actionnement de contacts d'un appareil de coupure électrique. Il comporte un circuit de traitement pour mettre en œuvre le procédé de diagnostic décrit ci-dessus.

Un appareil électrique comportant des contacts électriques de puissance actionnés par une bobine électromagnétique de commande selon l'invention comporte un dispositif de diagnostic l'état d'usure d'un appareil de coupure électrique connecté à ladite bobine électromagnétique d'actionnement desdits contacts pour mettre en œuvre le procédé de diagnostic décrit ci-dessus.

Le dispositif et le procédé peuvent être mis en œuvre de manière permanente ou temporaire sur l'appareil à contrôler. Ils peuvent aussi être mis en œuvre sur des appareils électriques déjà installés. De plus, certaines étapes du procédé peuvent être effectuée en local près de l'appareil et d'autres étapes réalisées à distance ou centralisées. Par exemple les acquisitions des courbes CM peuvent être locale et le reste du traitement peut être réalisé à distance pour des calculs plus élaborés. Dans ce cas, les traitements sont partagés entre un module 7 local et un module 9 distants comme représenté sur la figure 1.

Plusieurs types de charges ou de catégories d'emploi sont identifiés lors des phases d'apprentissage et de contrôle. Le traitement des types de charges est fait de préférence de manière globale lors de la phase d'apprentissage de manière à tenir compte de situations différentes. Par exemple, plusieurs appareils seront utilisés durant une durée de vie pour des types de charge différents. Les courbes d'évolution des descripteurs seront représentatives de courbes avec des appareils ayant eu des charges ou des conditions d'utilisation différentes.

Les catégories d'emploi pour appareils électriques tel que des contacteurs électriques dépendent notamment :
- du type de charge : non inductive, inductive, moteur à bague, moteur à cage ;
- du type de commande : mise sous tension, coupure, démarrage, freinage, marche par à-coup ;
- du type d'applications : distribution, chauffage, compresseur, ventilation, ascenseurs, pompes, machines diverses ; et/ou
- de combinaisons de plusieurs critères.

Il est également possible d'identifier un type de charge ou un usage particulier et de caractériser le procédé en conséquence. Par exemple pour des charges capacitives ou autres.

Des classes d'usure pour chaque catégorie d'emploi sont définies par des descripteurs. Elles permettent de caractériser l'état du produit et d'avoir une indication de la durée de vie du produit.

Une liste des principales classes non limitative peut être :
- Classe 1 : produit neuf ou en rodage
- Classe 2 : produit en utilisation
- Classe 3 : produit usé
- Classe 4 : produit en fin de vie

Dans les modes de réalisation préférentiels décrits ci-dessus, l'évaluation de l'usure des contacts est faite avantageusement à partir de la mesure de la tension de la bobine du contacteur. Cependant d'autres signaux peuvent être utilisés, notamment un signal représentatif d'un courant circulant dans la bobine.

## Revendications

1. Procédé de diagnostic de l'état d'usure d'un appareil électrique (1) de coupure connecté à une bobine (4) d'actionnement de contacts (2) dudit appareil électrique (1), le procédé comportant une phase (15) de contrôle dudit appareil électrique (1),
- ladite phase de contrôle utilisant :
- des données d'apprentissage (CD1, CD2, CD3, CD4, CD5, CRU) chargées préalablement et correspondant à un type de produit représentatif dudit appareil électrique, et
- des données d'initialisation (CRP) correspondant audit appareil à contrôler et mémorisées lors d'une phase (14) d'initialisation,
et
- ladite phase (15) de contrôle comportant :
- la réception d'un signal de mesure représentatif d'une grandeur électrique de ladite bobine (4) ainsi que l'acquisition d'une courbe de mesure (CM) à l'ouverture dudit appareil électrique (1), ladite courbe de mesure (CM) représentant ledit signal en fonction du temps,
- la détermination (30, 31, 51) de valeur de descripteurs locaux (DL1, DL2, DL3, DL4, DL5) de ladite courbe de mesure (CM) en fonction de valeurs de ladite courbe de mesure (CM), de données d'initialisation (CRP) enregistrées, et de première données d'apprentissage (CRU) chargées,
- la détermination (52) du positionnement des valeurs de descripteurs locaux (DL1, DL2, DL3, DL4, DL5) de la courbe de mesure (CM) par rapport à des secondes données d'apprentissage (CD1, CD2, CD3, CD4, CD5), représentatives de courbes d'évolution (CD1, CD2, CD3, CD4, CD5) de descripteurs représentatifs de caractéristiques prédéfinies dudit signal électrique durant la vie dudit appareil électriques, et
- la détermination (32, 53-55) d'une classe d'état globale en fonction desdites valeurs de positionnements des valeurs de descripteurs locaux (DL1, DL2, DL3, DL4, DL5) et de la courbe de mesure (CM) par rapport aux dites secondes données d'apprentissage (CD1, CD2, CD3, CD4, CD5).

2. Procédé de diagnostic selon la revendication 1 **caractérisé en ce que** la détermination d'une classe d'état globale comporte :
- au moins trois détermination (52, 54) de classes d'état intermédiaires (CLI) en fonction de positionnements les plus proches desdits descripteurs locaux, et
- la sélection (55) de ladite classe globale en fonction desdites classes intermédiaires (32).

3. Procédé de diagnostic selon l'une des revendications 1 ou 2 **caractérisé en ce qu'**un premier descripteur (D1, DL1) est représentatif de la différence (20) de valeur entre deux points remarquables (21, 22) de la dite courbe de mesure (CM).

4. Procédé de diagnostic selon l'une quelconque des revendications 1 à 3 **caractérisé en ce que** :
- des données d'initialisation comportent au moins une courbe de référence propre (CRP) au produit à contrôler enregistrée au début de la vie du produit après stabilisation des mesures, et
- un second descripteur (D2, DL2) est représentatif de l'écart entre une courbe de mesure (CM) et ladite courbe de référence propre (CRP), plus la courbe de mesure (CM) est éloignée de la courbe de référence propre (CRP) plus l'appareil sera considéré comme usé.

5. Procédé de diagnostic selon l'une quelconque des revendications 1 à 4 **caractérisé en ce que** :
- des données d'apprentissage chargées comportent au moins une courbe de référence (CRU) d'un appareil usé correspondant à un signal électrique durant une ouverture d'un appareil usé, et
- un troisième descripteur (D3, DL3) est représentatif de l'écart entre une courbe de mesure (CM) et ladite courbe de référence usée (CRU), plus la courbe de mesure (CM) est proche de la courbe de référence usé (CRU) plus l'appareil sera considéré comme usé.

6. Procédé de diagnostic selon l'une quelconque des revendications 1 à 5 **caractérisé en ce qu'**un quatrième descripteur (D4, DL4) correspond à une surface de courbe ou à une intégrale entre deux points (24, 25) remarquable de la courbe le mesure (CM) ou à deux seuils (26, 27) de valeurs selon un premier sens de variation et selon un second sens de variation opposé.

7. Procédé de diagnostic selon l'une quelconque des revendications 1 à 6 **caractérisé en ce qu'**un cinquième descripteur (D4, DL4) correspond à une variation de valeur d'un point remarquable (22) tel que le changement de signe de la variation d'un signal sur la courbe de mesure (CM).

8. Procédé de diagnostic selon l'une quelconque des revendications 1 à 7 **caractérisé en ce que** lesdites courbes d'évolution de descripteurs (CD1, CD2, CD3, CD4, CD5) sont chargées sous un format de définition de segments de droite pour réduire l'espace mémoire nécessaire audites données d'apprentissage.

9. Procédé de diagnostic selon l'une quelconque des revendications 1 à 8 **caractérisé en ce que** des valeurs desdites courbes d'évolution de descripteurs (CD1, CD2, CD3, CD4, CD5) pré-chargées sont associées à des classes d'état ou d'usure d'appareils à contrôler.

10. Procédé de diagnostic selon l'une quelconque des revendications 1 à 9 **caractérisé en ce qu'**il comporte :
- une phase (11) d'apprentissage préalable pour relever durant un nombre de manoeuvre prédéterminée des données d'apprentissage représentatives :
- d'au moins une courbe (CRU) de référence d'un appareil usé correspondant à un signal électrique durant une ouverture dudit appareil usé, et
- d'au moins deux courbes (CD1, CD2, CD3, CD4, CD5) d'évolution de descripteurs représentatifs de caractéristiques prédéfinies dudit signal électrique durant la vie dudit appareil électrique,
- une mémorisation (12) desdites données d'apprentissage (CD1, CD2, CD3, CD4, CD5, CRU),
- le chargement (13) desdites données d'apprentissage (CD1, CD2, CD3, CD4, CD5, CRU), et
- l'utilisation (52, 53) des données d'apprentissage dans ladite phase (15) de contrôle dudit appareil électrique.

11. Procédé de diagnostic selon l'une quelconque des revendications 1 à 10 **caractérisé en ce qu'**il comporte :
- une phase d'initialisation (14) pour déterminer lesdites données d'initialisation comportant ladite courbe de référence propre (CRP) du produit à contrôler déterminée :
- après un nombre (Nstable) prédéterminé de mesures (43), et/ou
- lorsque la courbe de mesure (CM) varie très peu entre deux mesures consécutives (CMn, CMn-1).
- l'enregistrement (44) de ladite courbe de référence propre, et
- l'utilisation (51) des données d'initialisation dans ladite phase (15) de contrôle dudit appareil électrique.

12. Dispositif de diagnostic (10) de l'état d'usure d'un appareil (1) de coupure électrique connecté à une bobine électromagnétique (4) d'actionnement de contacts (2) dudit appareil de coupure électrique **caractérisé en ce que** le dispositif de diagnostic comporte un circuit (10) de traitement configuré pour mettre en œuvre le procédé de diagnostic selon les revendications 1 à 11.

13. Dispositif de diagnostic selon la revendication 12 **caractérisé en ce que** le circuit (10) de traitement comporte un module (7) de traitement du diagnostic local proche dudit l'appareil relié à un module de traitement extérieur (9) distant dudit appareil.

14. Appareil électrique (1) de coupure comportant des contacts (2) électriques de puissance actionnés par une bobine (4) électromagnétique de commande **caractérisé en ce qu'**il comporte un dispositif de diagnostic (10) de l'état d'usure dudit appareil électrique (1) selon l'une des revendications 12 ou 13.

## Patentansprüche

1. Verfahren für die Diagnose des Abnutzungszustandes eines elektrischen Stromunterbrechergeräts (1), das mit einer Spule (4) für die Betätigung von Kontakten (2) des elektrischen Geräts (1) verbunden ist,
wobei das Verfahren eine Phase (15) der Kontrolle des elektrischen Geräts (1) umfasst,
- wobei die Kontrollphase Folgendes verwendet:
- Lerndaten (CD1, CD2, CD3, CD4, CD5, CRU), die vorher geladen werden und einem Produkttyp entsprechen, der das elektrische Gerät repräsentiert, und
- Initialisierungsdaten (CRP), die dem zu kontrollierenden Gerät entsprechen und während einer Initialisierungsphase (14) gespeichert werden, und
- wobei die Kontrollphase (15) Folgendes umfasst:
- Empfangen eines Messsignals, das eine elektrische Größe der Spule (4) repräsentiert, und
- Erfassen einer Messkurve (CM) beim Öffnen des elektrischen Geräts (1), wobei die Messkurve (CM) das Signal als Funktion der Zeit repräsentiert,
- Bestimmen (30, 31, 51) des Wertes lokaler Deskriptoren (DL1, DL2, DL3, DL4, DL5) der Messkurve (CM) als Funktion von Werten der Messkurve (CM), von aufgezeichneten Initialisierungsdaten (CRP) und von ersten geladenen Lerndaten (CRU),
- Bestimmen (52) der Positionierung der Werte lokaler Deskriptoren (DL1, DL2, DL3, DL4, DL5) der Messkurve (CM) in Bezug auf zweite Lerndaten (CD1, CD2, CD3, CD4, CD5), die Entwicklungskurven (CD1, CD2, CD3, CD4, CD5) von Deskriptoren repräsentieren, die im Voraus definierte Charakteristiken des elektrischen Signals während der Lebensdauer des elektrischen Geräts repräsentieren, und
- Bestimmen (32, 53-55) einer globalen Zustandsklasse als Funktion der Werte der Positionierungen der Werte lokaler Deskriptoren (DL1, DL2, DL3, DL4, DL5) und der Messkurve (CM) in Bezug auf die zweiten Lerndaten (CD1, CD2, CD3, CD4, CD5).

2. Diagnoseverfahren nach Anspruch 1, **dadurch gekennzeichnet, dass** das Bestimmen einer globalen Zustandsklasse Folgendes umfasst:
- wenigstens drei Bestimmungen (52, 54) von Zwischenzustandsklassen (CLI) als Funktion von Positionierungen der nächsten lokalen Deskriptoren und
- Auswählen (55) der globalen Klasse als Funktion der Zwischenklassen (32).

3. Diagnoseverfahren nach einem der Ansprüche 1 oder 2, **dadurch gekennzeichnet, dass** ein erster Deskriptor (D1, DL1) die Differenz (20) des Wertes zwischen zwei markanten Punkten (21, 22) der Messkurve (CM) repräsentiert.

4. Diagnoseverfahren nach einem der Ansprüche 1 bis 3, **dadurch gekennzeichnet, dass**:
- die Initialisierungsdaten wenigstens eine Referenzkurve (CRP) umfassen, die dem zu kontrollierenden Produkt eigen ist und am Beginn der Lebensdauer des Produktes nach der Stabilisierung der Messungen aufgezeichnet wird, und
- ein zweiter Deskriptor (D2, DL2) den Abstand zwischen einer Messkurve (CM) und der Eigen-Referenzkurve (CRP) repräsentiert, wobei das Gerät als umso stärker abgenutzt angesehen wird, je weiter die Messkurve (CM) von der Eigen-Referenzkurve (CRP) entfernt ist.

5. Diagnoseverfahren nach einem der Ansprüche 1 bis 4, **dadurch gekennzeichnet, dass**:
- geladene Lerndaten wenigstens eine Referenzkurve (CRU) eines abgenutzten Geräts enthalten, die einem elektrischen Signal während einer Öffnung eines abgenutzten Geräts entspricht, und
- ein dritter Deskriptor (D3, DL3) den Abstand zwischen einer Messkurve (CM) und der Abnutzungs-Referenzkurve (CRU) repräsentiert, wobei das Gerät als umso stärker abgenutzt angesehen wird, je näher die Messkurve (CM) sich bei der Abnutzungs-Referenzkurve (CRU) befindet.

6. Diagnosevorrichtung nach einem der Ansprüche 1 bis 5, **dadurch gekennzeichnet, dass** ein vierter Deskriptor (D4, DL4) einer Kurvenoberfläche oder einem integral zwischen zwei markanten Punkten (24, 25) der Messkurve (CM) oder zwischen zwei Schwellenwerten (26, 27) in einem ersten Änderungsrichtungssinn bzw. in einem zweiten, entgegengesetzten Änderungsrichtungssinn entspricht.

7. Diagnoseverfahren nach einem der Ansprüche 1 bis 6, **dadurch gekennzeichnet, dass** ein fünfter Deskriptor (D4, DL4) einer Änderung des Wertes eines markanten Punkts (22) wie etwa dem Vorzeichenwechsel der Änderung eines Signals auf der Messkurve (CM) entspricht.

8. Diagnoseverfahren nach einem der Ansprüche 1 bis 7, **dadurch gekennzeichnet, dass** die Entwicklungskurven von Deskriptoren (CD1, CD2, CD3, CD4, CD5) in einem Format für die Definition von Geradensegmenten geladen werden, um den für die Lerndaten erforderlichen Speicherraum zu verringern.

9. Diagnoseverfahren nach einem der Ansprüche 1 bis 8, **dadurch gekennzeichnet, dass** die Entwicklungskurven von Deskriptoren (CD1, CD2, CD3, CD4, CD5), die im Voraus geladen werden, Zustands- oder Abnutzungsklassen von zu kontrollierenden Geräten zugeordnet sind.

10. Diagnoseverfahren nach einem der Ansprüche 1 bis 9, **gekennzeichnet durch**:
- eine vorherige Lernphase (11), um während einer vorgegebenen Anzahl von Betätigungen Lerndaten abzugreifen, die Folgendes repräsentieren:
- wenigstens eine Referenzkurve (CRU) eines abgenutzten Geräts, die einem elektrischen Signal während eines Öffnens des abgenutzten Geräts entspricht, und
- wenigstens zwei Kurven (CD1, CD2, CD3, CD4, CD5) der Entwicklung von Deskriptoren, die im Voraus definierte Charakteristiken des elektrischen Signals während der Lebensdauer des elektrischen Geräts repräsentieren,
- Speichern (12) der Lerndaten (CD1, CD2, CD3, CD4, CD5, CRU),
- Laden (13) der Lerndaten (CD1, CD2, CD3, CD4, CD5, CRU) und
- Verwenden (52, 53) der Lerndaten in der Phase (15) der Kontrolle des elektrischen Geräts.

11. Diagnoseverfahren nach einem der Ansprüche 1 bis 10, **gekennzeichnet durch**:
- eine Initialisierungsphase (14), um die Initialisierungsdaten zu bestimmen, die die Eigen-Referenzkurve (CRP) des bestimmten zu kontrollierenden Produkts enthalten:
- nach einer vorgegebenen Anzahl (Nstable) von Messungen (43) und/oder
- dann, wenn sich die Messkurve (CM) zwischen zwei aufeinanderfolgenden Messungen (CMn, CMn-1) sehr wenig ändert,
- Aufzeichnen (44) der Eigen-Referenzkurve und
- Verwenden (51) der Initialisierungsdaten in der Phase (15) der Kontrolle des elektrischen Geräts.

12. Vorrichtung für die Diagnose (10) des Abnutzungszustands eines elektrischen Stromunterbrechergeräts (1), das mit einer elektromagnetischen Spule (4) für die Betätigung von Kontakten (2) des elektrischen Stromunterbrechergeräts verbunden ist, **dadurch gekennzeichnet, dass** die Diagnosevorrichtung eine Verarbeitungsschaltung (10) umfasst, die konfiguriert ist, das Diagnoseverfahren nach den Ansprüchen 1 bis 11 auszuführen.

13. Diagnosevorrichtung nach Anspruch 12, **dadurch gekennzeichnet, dass** die Verarbeitungsschaltung (10) ein Modul (7) für die lokale Verarbeitung der Diagnose in der Nähe des Geräts enthält, das mit einem externen Verarbeitungsmodul (9) entfernt von dem Gerät verbunden ist.

14. Elektrisches Stromunterbrechergerät (1), das elektrische Leistungskontakte (2) enthält, die durch eine elektromagnetische Steuerspule (4) betätigt werden, **dadurch gekennzeichnet, dass** es eine Vorrichtung (10) für die Diagnose des Abnutzungszustands der elektrischen Geräts (1) nach einem der Ansprüche 12 oder 13 enthält.

## Claims

1. Method for diagnosing the state of wear of an electrical switching unit (1) connected to a coil (4) for actuating contacts (2) of said electrical unit (1), the method comprising a phase (15) of checking of said electrical unit (1),
- said checking phase using:
- learning data (CD1, CD2, CD3, CD4, CD5, CRU) loaded previously and corresponding to a type of product representative of said electrical unit, and
- initialization data (CRP) corresponding to said unit to be controlled and stored in an initialization phase (14), and
- said checking phase (15) comprising:
- the reception of a measurement signal representative of an electrical quantity of said coil (4) and the acquisition of a measurement curve (CM) on the opening of said electrical unit (1), said measurement curve (CM) representing said signal as a function of time,
- the determination (30, 31, 51) of values of local descriptors (DL1, DL2, DL3, DL4, DL5) of said measurement curve (CM) as a function of values of said measurement curve (CM), of stored initialization data (CRP), and of first loaded learning data (CRU),
- the determination (52) of the positioning of the values of local descriptors (DL1, DL2, DL3, DL4, DL5) of the measurement curve (CM) with respect to second learning data (CD1, CD2, CD3, CD4, CD5), representative of trend curves (CD1, CD2, CD3, CD4, CD5) of descriptors representative of predefined characteristics of said electrical signal during the life of said electrical unit, and
- the determination (32, 53-55) of an overall state class as a function of said values of positionings of local descriptor values (DL1, DL2, DL3, DL4, DL5) and of the measurement curve (CM) with respect to said second learning data (CD1, CD2, CD3, CD4, CD5).

2. Diagnostic method according to Claim 1, **characterized in that** the determination of an overall state class comprises:
- at least three determinations (52, 54) of intermediate state classes (CLI) as a function of positionings closest to said local descriptors, and
- the selection (55) of said overall class as a function of said intermediate classes (32).

3. Diagnostic method according to one of Claims 1 and 2, **characterized in that** a first descriptor (D1, DL1) is representative of the difference (20) in value between two noteworthy points (21, 22) of said measurement curve (CM).

4. Diagnostic method according to any one of Claims 1 to 3, **characterized in that**:
- initialization data comprise at least one reference curve (CRP) specific to the product to be checked stored at the start of the life of the product after stabilization of the measurements, and
- a second descriptor (D2, DL2) is representative of the deviation between a measurement curve (CM) and said specific reference curve (CRP), the more the distance between the measurement curve (CM) and the specific reference curve (CRP) increases, the more the unit will be considered to be worn.

5. Diagnostic method according to any one of Claims 1 to 4, **characterized in that**:
- loaded learning data comprise at least one reference curve (CRU) of a worn unit corresponding to an electrical signal during an opening of a worn unit, and
- a third descriptor (D3, DL3) is representative of the deviation between a measurement curve (CM) and said worn reference curve (CRU), the closer the measurement curve (CM) is to the worn reference curve (CRU), the more the unit will be considered to be worn.

6. Diagnostic method according to any one of Claims 1 to 5, **characterized in that** a fourth descriptor (D4, DL4) corresponds to a curve surface or to an integral between two noteworthy points (24, 25) of the measurement curve (CM) or to two thresholds (26, 27) of values according to a first direction of variation and according to an opposite second direction of variation.

7. Diagnostic method according to any one of Claims 1 to 6, **characterized in that** a fifth descriptor (D4, DL4) corresponds to a variation in value of a noteworthy point (22) such as the change of sign of the variation of a signal on the measurement curve (CM).

8. Diagnostic method according to any one of Claims 1 to 7, **characterized in that** said trend curves of descriptors (CD1, CD2, CD3, CD4, CD5) are loaded in a straight segment definition format to reduce the memory space required for said learning data.

9. Diagnostic method according to any one of Claims 1 to 8, **characterized in that** values of said preloaded trend curves of descriptors (CD1, CD2, CD3, CD4, CD5) are associated with state or wear classes of units to be controlled.

10. Diagnostic method according to any one of Claims 1 to 9, **characterized in that** it comprises:
- a preliminary learning phase (11) for recording, during a determined number of manoeuvres, learning data representative:
- of at least one reference curve (CRU) of a worn unit corresponding to an electrical signal during an opening of said worn unit, and
- of at least two trend curves (CD1, CD2, CD3, CD4, CD5) of descriptors representative of predefined characteristics of said electrical signal during the life of said electrical unit,
- storage (12) of said learning data (CD1, CD2, CD3, CD4, CD5, CRU),
- loading (13) of said learning data (CD1, CD2, CD3, CD4, CD5, CRU), and
- use (52, 53) of the learning data in said phase (15) of checking of said electrical unit.

11. Diagnostic method according to any one of Claims 1 to 10, **characterized in that** it comprises:
- an initialization phase (14) for determining said initialization data comprising said specific reference curve (CRP) of the product to be checked, determined:
- after a predetermined number (Nstable) of measurements (43), and/or
- when the measurement curve (CM) varies very little between two consecutive measurements (CMn, CMn-1),
- storage (44) of said specific reference curve, and
- use (51) of the initialization data in said phase (15) of checking of said electrical unit.

12. Device (10) for diagnosing the state of wear of an electrical switching unit (1) connected to an electromagnetic coil (4) for actuating contacts (2) of said electrical switching unit, **characterized in that** the diagnostic device comprises a processing circuit (10) configured to implement the diagnostic method according to Claims 1 to 11.

13. Diagnostic device according to Claim 12, **characterized in that** the processing circuit (10) comprises a local diagnostic processing module (7) close to said unit linked to an external processing module (9) remote from said unit.

14. Electrical switching unit (1) comprising power electrical contacts (2) actuated by an electromagnetic control coil (4), **characterized in that** it comprises a device (10) for diagnosing the state of wear of said electrical unit (1) according to one of Claims 12 and 13.
